# EUROPEAN PATENT SPECIFICATION

(11) **EP 3 493 661 B1**
(45) Date of publication and mention of the grant of the patent: **18.10.2023**
(21) Application number: 18175710.5
(22) Date of filing: 04.06.2018
(51) Int. Cl.: H05K 7/14

(54) **SUPPORTING ASSEMBLY SUITABLE FOR RACK**
TRAGANORDNUNG FÜR GESTELL
ENSEMBLE DE SUPPORT ADAPTÉ À UNE CRÉMAILLÈRE

(30) Priority: 01.12.2017 TW 106142462
(43) Date of publication of application: 05.06.2019
(73) Proprietor: King Slide Works Co., Ltd., Kaohsiung City (TW); King Slide Technology Co., Ltd., Kaohsiung City (TW)
(72) Inventor: CHEN, Ken-Ching, Kaohsiung City (TW); YANG, Shun-Ho, Kaohsiung City (TW); GUO, Mei-Zuo, Kaohsiung City (TW); WANG, Chun-Chiang, Kaohsiung City (TW)
(74) Representative: Viering, Jentschura & Partner mbB Patent- und Rechtsanwälte

(56) References cited:
- EP-A1- 2 764 796
- EP-A1- 3 032 930
- EP-A1- 3 122 164
- EP-A2- 3 136 830
- US-A1- 2002 084 734

## Description

### Field of the Invention

The present invention relates to a supporting assembly and more particularly to one for use with a rack.

### Background of the Invention

US Patent No. 6,230,903 B1 discloses a rack slide mounting system. As shown in FIG. 2 accompanying the specification of the US patent, the system includes a first mounting bracket 27 and a second mounting bracket 47. The first mounting bracket 27 is provided with a plurality of elongated slots 33, and the second mounting bracket 47 is provided with a plurality of elongated slots 53. The plural studs 31 and 51 on a slide mechanism 21 are passed through the elongated slots respectively and are each connected with a nut 29 or 48 so that the total length to which the first mounting bracket 27 and the second mounting bracket 47 extend can be adjusted, allowing the two mounting brackets to carry a chassis through the slide mechanism 21.

The first mounting bracket 27 and the second mounting bracket 47 of the bracket assembly disclosed in the afore-cited patent are two separate components, but this structural configuration does not always meet market demands.

EP 2 764 796 A1 discloses a supporting assembly, comprising: a first bracket including a first end portion and a second end portion; a supporting frame connected to the first bracket at a position adjacent to the second end portion of the first bracket, wherein the supporting frame has a first supporting section; and a second bracket; wherein one of the first bracket and the supporting frame is provided with a second supporting section, and the first supporting section and the second supporting section jointly constitute a supporting channel for supporting the second bracket. Some further devices are known from EP 3 032 930 A1, from EP 3 136 830 A2, from EP 3 122 164 A1, and from US 2002/084734 A1.

### Summary of the Invention

One objective of the present invention is to provide a supporting assembly whose two brackets are mounted with respect to each other via a supporting frame.

According to the present invention, a supporting assembly as defined by claim 1 is provided. The dependent claims show some examples of such a supporting assembly.

According to a non-claimed example, a supporting assembly includes a first bracket, a supporting frame, and a second bracket. The first bracket includes a first end portion and a second end portion. The supporting frame is connected to the first bracket at a position adjacent to the second end portion of the first bracket and has a first supporting section. One of the first bracket and the supporting frame is provided with a second supporting section. The first supporting section and the second supporting section jointly constitute a supporting channel for supporting the second bracket.

Preferably, the second bracket is mounted to the first bracket through the supporting channel, and the first bracket and the second bracket include a first mounting member and a second mounting member respectively, wherein the second mounting member is away from the first mounting member.

The first bracket has a first lateral side and a second lateral side. The first lateral side is provided with a carrying portion while the first supporting section is located on the second lateral side.

The second supporting section is located on the second lateral side and, preferably, extends in a second direction.

The first bracket has a first feature, and the second bracket has a second feature. The first feature and the second feature do not contact each other when the first bracket and the second bracket are extended to a first length. The first feature and the second feature contact each other when the first bracket and the second bracket are extended to a second length.

Preferably, the first feature is one of a protruding portion and an elastic arm, and the second feature is the other of the protruding portion and the elastic arm.

The supporting frame is a separate component connected to the first bracket.

Preferably, the first bracket has the second supporting section.

Preferably, the first bracket includes a sidewall, and the sidewall has not only the first lateral side and the second lateral side, but also an upper portion and a lower portion. The first supporting section is adjacent to the lower portion while the second supporting section is adjacent to the upper portion.

Preferably, the first supporting section is connected with a first bent section.

Preferably, the second supporting section is connected with a second bent section.

Preferably, the second bracket includes an upper wall, a lower wall, and a sidewall connected between the upper wall and the lower wall, wherein the lower wall and the upper wall correspond in position to the first supporting section and the second supporting section respectively.

The supporting frame is a separate component connected to the first bracket and, preferably, has the second supporting section and an intermediate wall connected between the first supporting section and the second supporting section. It is also preferable that the first supporting section and the second supporting section are connected with a first bent section and a second bent section respectively.

According to another non-claimed example, a supporting assembly adapted to be mounted on a rack includes a first bracket, a supporting frame, and a second bracket. The first bracket includes a sidewall. The sidewall of the first bracket includes a first end portion and a second end portion, and a first mounting member is arranged adjacent to the first end portion. The sidewall of the first bracket also has a first lateral side and a second lateral side. The supporting frame is connected to the second lateral side and has a first supporting section. The second bracket includes a sidewall and a second mounting member. One of the first bracket and the supporting frame is provided with a second supporting section. The first supporting section and the second supporting section jointly constitute a supporting channel for supporting the sidewall of the second bracket. The first bracket is mounted at a first position on a first side of the rack through the first mounting member, and the second bracket is mounted at a second position on the first side of the rack through the second mounting member.

The sidewall of the first bracket has a carrying portion on the first lateral side so that the supporting assembly can carry an external object through the carrying portion.

The supporting frame is adjacent to the second end portion of the first bracket and is a separate component connected to the first bracket.

### Brief Description of the Drawings

FIG. 1 shows how an object is mounted on a rack through a pair of supporting assemblies according to a first design not covered by claim 1;
FIG. 2 is a perspective view of the supporting assembly according to the first design shown in FIG. 1;
FIG. 3 is an exploded perspective view of the supporting assembly according to the first design shown in FIG. 1 and FIG. 2;
FIG. 4 is a sectional view of the supporting assembly according to the first design shown in FIG. 1 - FIG. 3, showing how the supporting assembly supports an object;
FIG. 5 shows the pair of supporting assemblies mounted on a rack and extended to a first length according to the first design shown in FIG. 1 - FIG. 4;
FIG. 6 is an enlarged view of the circled area A in FIG. 5;
FIG. 7 is an enlarged view of the circled area B in FIG. 5;
FIG. 8 shows the pair of supporting assemblies mounted on a rack and extended to a second length according to the first design shown in FIG. 1 - FIG. 7;
FIG. 9 is an enlarged view of the circled area A in FIG. 8;
FIG. 10 is an exploded perspective view of a supporting assembly according to the first embodiment of the invention;
FIG. 11 is an assembled perspective view of the supporting assembly according to the first embodiment of the invention;
FIG. 12 is a sectional view of the supporting assembly according to the first embodiment of the invention;
FIG. 13 is an exploded perspective view of a supporting assembly according to the second embodiment of the invention;
FIG. 14 is an assembled perspective view of the supporting assembly according to the second embodiment of the invention; and
FIG. 15 is a sectional view of the supporting assembly according to the second embodiment of the invention.

### Detailed Description of the Invention

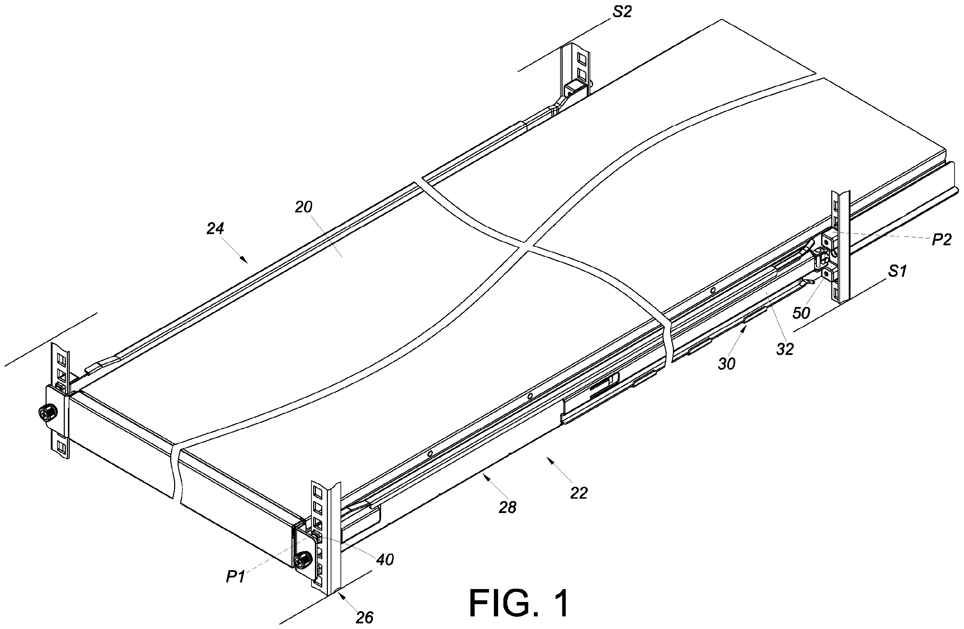

FIG. 1 shows how an object 20, e.g., the chassis of a piece of electronic equipment, is mounted on a rack 26 via a pair of supporting assemblies 22, 24 according to a first non-claimed design. More specifically, the supporting assembly 22 includes a first bracket 28, a supporting frame 30, and a second bracket 32. The first bracket 28 is mounted at a first position P 1 on a first side S 1 of the rack 26, and the second bracket 32 is mounted at a second position P2 on the first side S 1 of the rack 26. The other supporting assembly 24 is mounted on a second side S2 of the rack 26 in a similar manner.

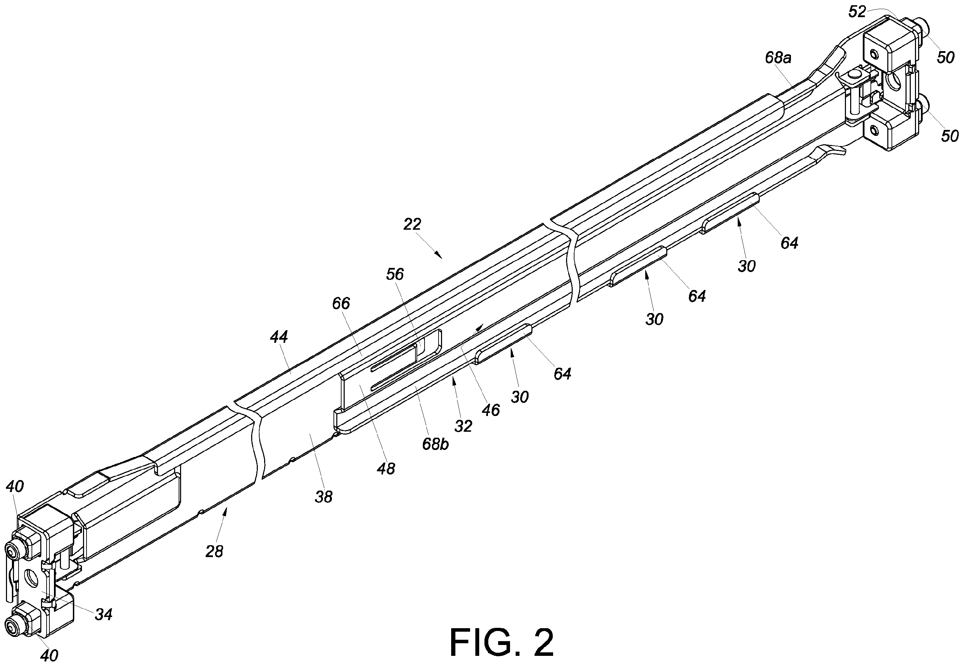

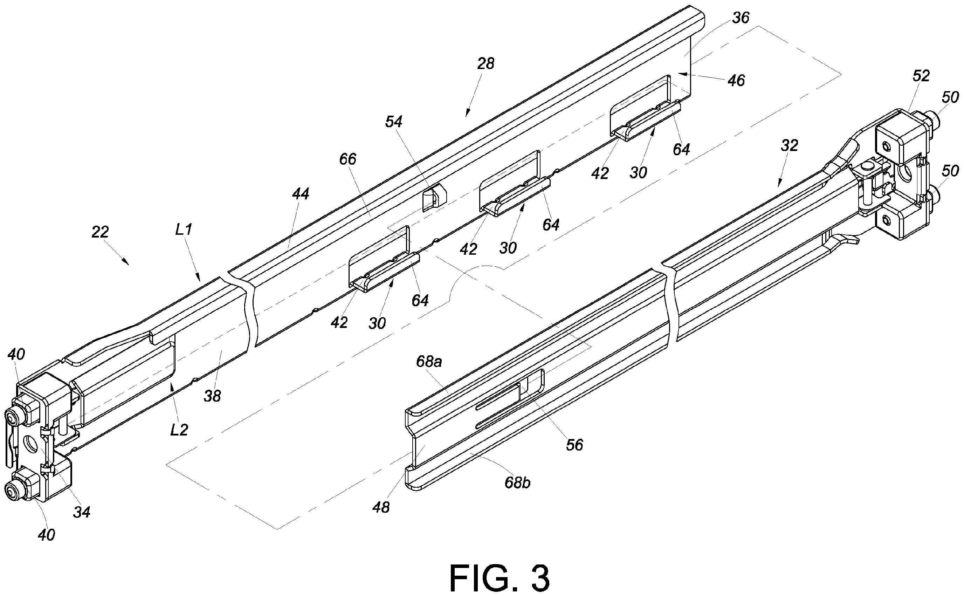

FIG. 2 to FIG. 4 more clearly show the components of the supporting assembly 22 and how the components are arranged in relation to one another. The first bracket 28 of the supporting assembly 22 includes a first end portion 34 and a second end portion 36, such as but not limited to a front end portion and a rear end portion. Preferably, the first bracket 28 includes a sidewall 38 of a predetermined length, and the sidewall 38 includes the first end portion 34 and the second end portion 36, with at least one first mounting member 40 (e.g., two first mounting members 40) arranged adjacent to the first end portion 34. The first bracket 28 is mounted at the first position P1 on the first side S 1 of the rack 26 through the first mounting members 40. The sidewall 38 of the first bracket 28 has a first lateral side L1 and a second lateral side L2. The second lateral side L2 is on the opposite side of the first lateral side L1; in other words, the first lateral side L1 and the second lateral side L2 are two opposite sides of the sidewall 38.

In the first design, the supporting frame 30 and the first bracket 28 are integrally formed. The supporting frame 30 is connected to the first bracket 28 at a position adjacent to the second end portion 36. More specifically, the supporting frame 30 is connected to the sidewall 38 of the first bracket 28 and extends from the second lateral side L2. Here, three supporting frames 30 are provided by way of example. In practice, however, only one supporting frame 30 suffices. Each supporting frame 30 has a first supporting section 42. Either the first bracket 28 or the supporting frames 30 are provided with a second supporting section 44. Here, by way of example, it is the first bracket 28 that is provided with the second supporting section 44. The first supporting sections 42 and the second supporting section 44 jointly constitute a supporting channel 46 for supporting the second bracket 32. The second bracket 32 is mounted on the first bracket 28 through the supporting channel 46.

The second bracket 32 includes a sidewall 48 and at least one second mounting member 50 (e.g., two second mounting members 50). The sidewall 48 of the second bracket 32 has a predetermined length and is supported in the supporting channel 46. The second mounting members 50 are arranged adjacent to an end portion 52 of the sidewall 48 of the second bracket 32 and are outside the supporting channel 46. The second mounting members 50 are away from the first mounting members 40. The second bracket 32 is mounted at the second position P2 on the first side S 1 of the rack 26 through the second mounting members 50.

The sidewall 38 of the first bracket 28 has a first feature 54, and the sidewall 48 of the second bracket 32 has a second feature 56. Here, the first feature 54 is a protruding portion, and the second feature 56 is an elastic arm. In embodiments that are not shown herein, the first feature 54 may be an elastic arm instead while the second feature 56 is a protruding portion; the present invention has no limitation in this regard. That is to say, the first feature 54 is one of a protruding portion and an elastic arm, and the second feature 56 is the other of the protruding portion and the elastic arm. The elastic arm can be moved over the protruding portion elastically in the course in which the second bracket 32 is mounted to the first bracket 28.

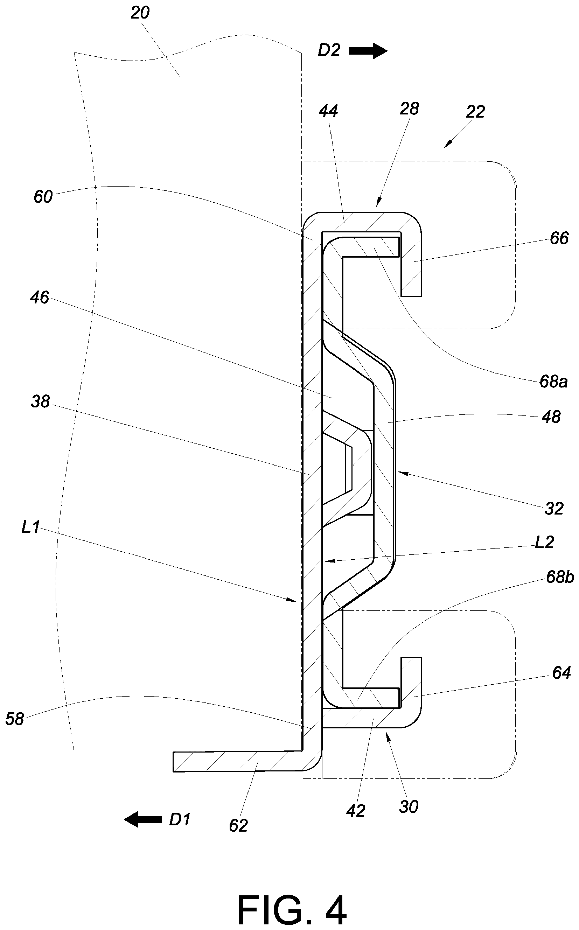

As shown in FIG. 4, the first supporting sections 42 and the second supporting section 44 are located on the second lateral side L2 of the sidewall 38 of the first bracket 28, and, preferably, the sidewall 38 of the first bracket 28 has a lower portion 58 and an upper portion 60, the first supporting sections 42 are adjacent to the lower portion 58, and the second supporting section 44 is adjacent to the upper portion 60.

Preferably, as shown in FIG. 4, the first supporting sections 42 extend substantially perpendicularly from the lower portion 58, and the second supporting section 44 extends substantially perpendicularly from the upper portion 60.

As shown in FIG. 4, a carrying portion 62 is arranged on the first lateral side L1 of the sidewall 38 of the first bracket 28, preferably, is substantially adjacent to the lower portion 58, and extends in a first direction D1. The carrying portion 62 is configured to carry a bottom portion of the object 20 in such a way that a lateral side of the object 20 can be pressed against and thereby supported by the first lateral side L1 of the sidewall 38 of the first bracket 28. The first supporting sections 42 and the second supporting section 44 extend in a second direction D2 that is different from the first direction D1.

Preferably, as shown in FIG. 4, each first supporting section 42 is connected with a first bent section 64, and the second supporting section 44 is connected with a second bent section 66. Here, by way of example, each first bent section 64 is substantially perpendicularly connected to the corresponding first supporting section 42 and extends toward the supporting channel 46, and the second bent section 66 is substantially perpendicularly connected to the second supporting section 44 and extends toward the supporting channel 46.

Preferably, as shown in FIG. 4, the second bracket 32 includes an upper wall 68a and a lower wall 68b, the sidewall 48 is connected between the upper wall 68a and the lower wall 68b, the lower wall 68b corresponds in position to the first supporting sections 42, and the upper wall 68a corresponds in position to the second supporting section 44.

Preferably, as shown in FIG. 4, the first bent sections 64 and the second bent section 66 help keep the second bracket 32 in the supporting channel 46.

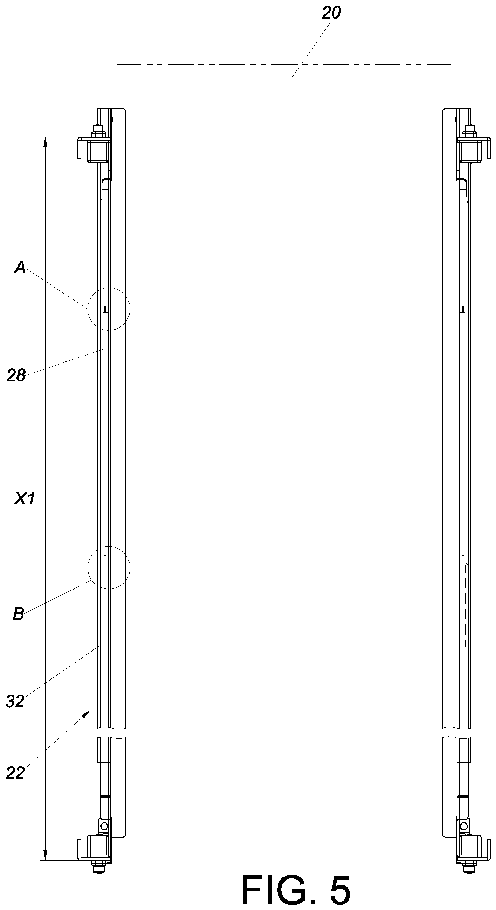

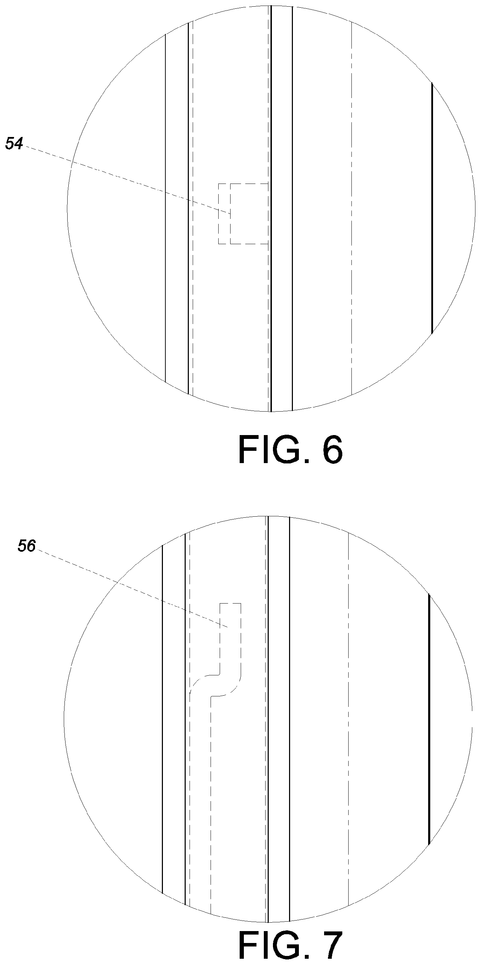

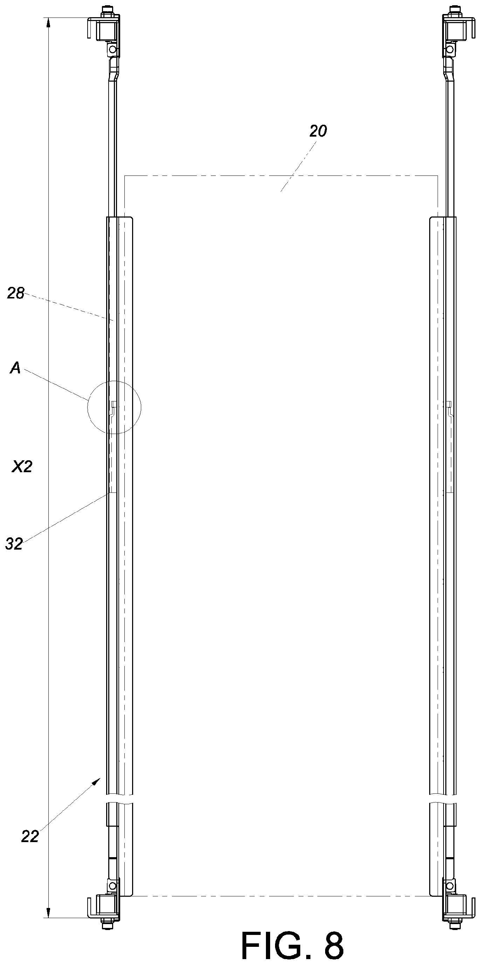

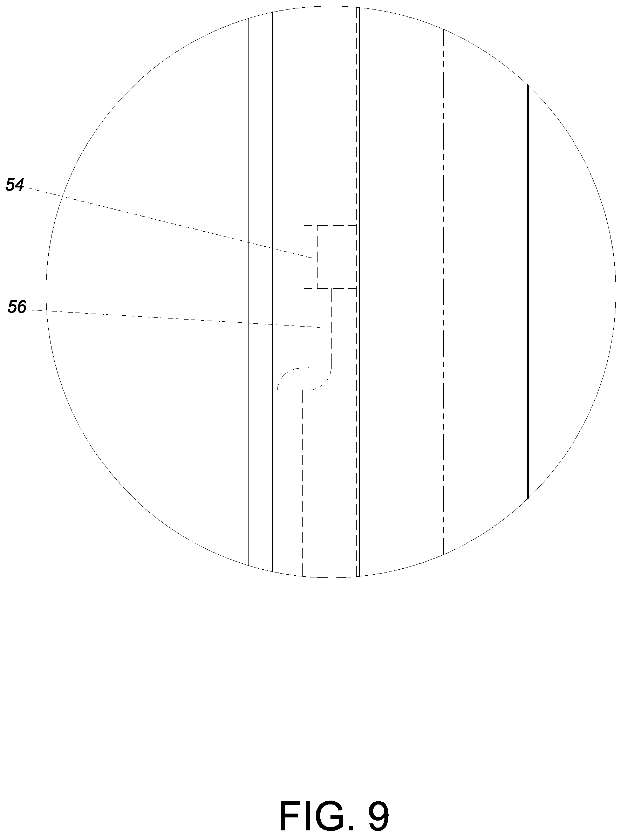

Referring to FIG. 5 to FIG. 7, the first feature 54 and the second feature 56 do not contact each other when the first bracket 28 and the second bracket 32 are extended to a first length X1. The second bracket 32 in this state can be moved with respect to the first bracket 28 through the supporting channel 46 as shown in FIG. 8 and FIG. 9. Once the first bracket 28 and the second bracket 32 are extended to a second length X2, the first feature 54 and the second feature 56 contact each other, thereby setting a limit to the adjustment (i.e., relative displacement) of the first bracket 28 and the second bracket 32 for the sake of safety.

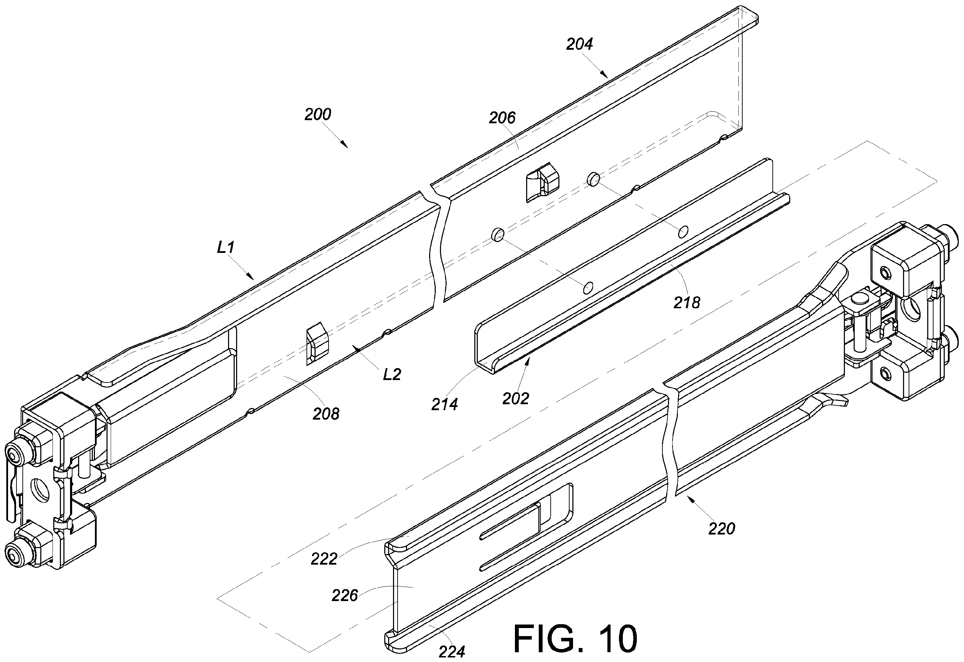

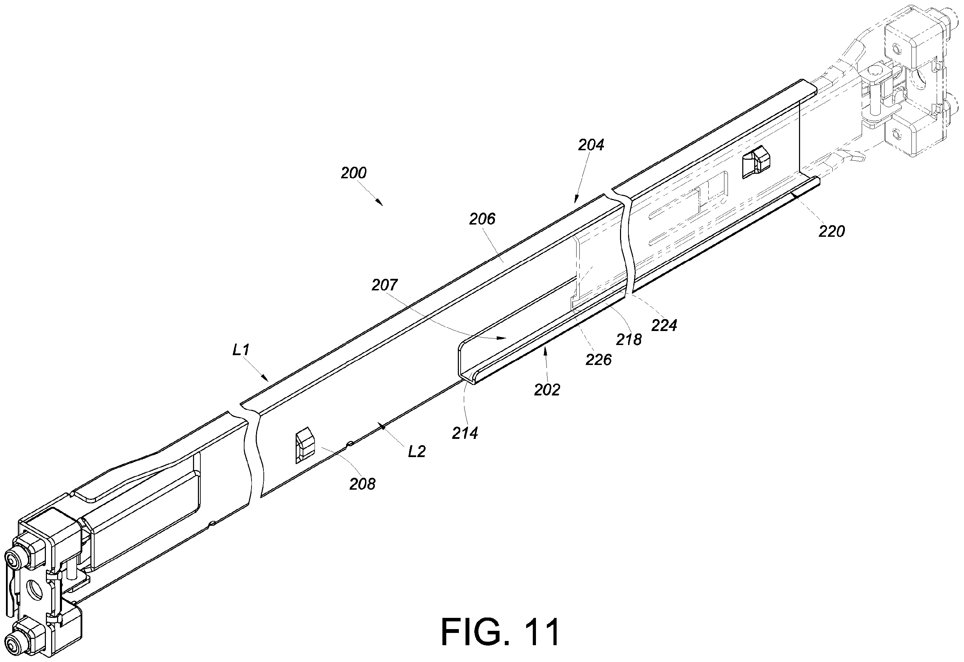

FIG. 10 to FIG. 12 show a supporting assembly 200 according to the first embodiment of the present invention. The supporting assembly 200 is different from the supporting assembly 22 of the first design substantially in that the supporting frame 202 is a separate component connected to the first bracket 204. For example, the supporting frame 202 may be fixedly connected to the first bracket 204 by riveting or soldering, or the supporting frame 202 may be detachably connected to the first bracket 204 through mechanical engagement or by a threaded means.

The first bracket 204 has a second supporting section 206 while the supporting frame 202 has a first supporting section 214. The first supporting section 214 and the second supporting section 206 jointly constitute a supporting channel 207 for supporting the sidewall 226 of the second bracket 220.

The first bracket 204 includes a sidewall 208, and the sidewall 208 has a first lateral side L1 and a second lateral side L2.

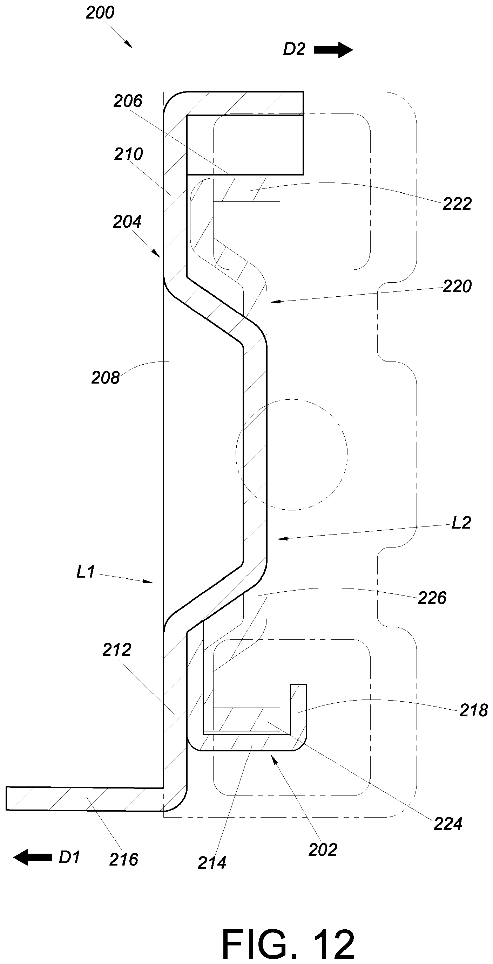

As shown in FIG. 12, the sidewall 208 of the first bracket 204 has an upper portion 210 and a lower portion 212, and the first supporting section 214 and the second supporting section 206 are located on the second lateral side L2. The first supporting section 214 is adjacent to the lower portion 212 while the second supporting section 206 is adjacent to the upper portion 210. A carrying portion 216 is arranged on the first lateral side L1 and extends in a first direction D1. The first supporting section 214 and the second supporting section 206 extend in a second direction D2. The first supporting section 214 is connected with a first bent section 218. Here, the first bent section 218 is substantially perpendicularly connected to the first supporting section 214 by way of example. The second bracket 220 includes an upper wall 222 and a lower wall 224 in addition to the sidewall 226, which is connected between the upper wall 222 and the lower wall 224. The lower wall 224 corresponds in position to the first supporting section 214 while the upper wall 222 corresponds in position to the second supporting section 206.

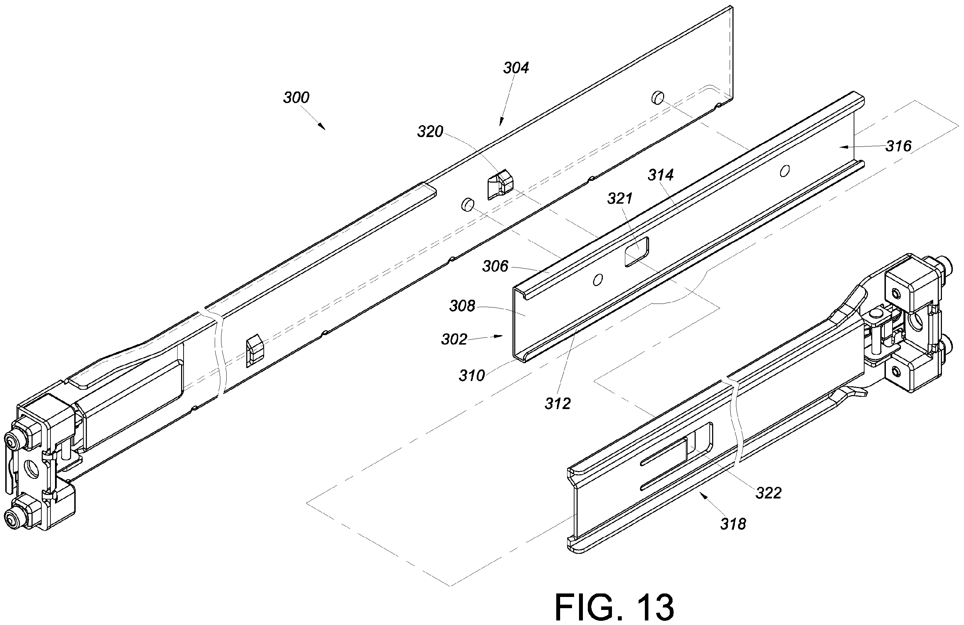

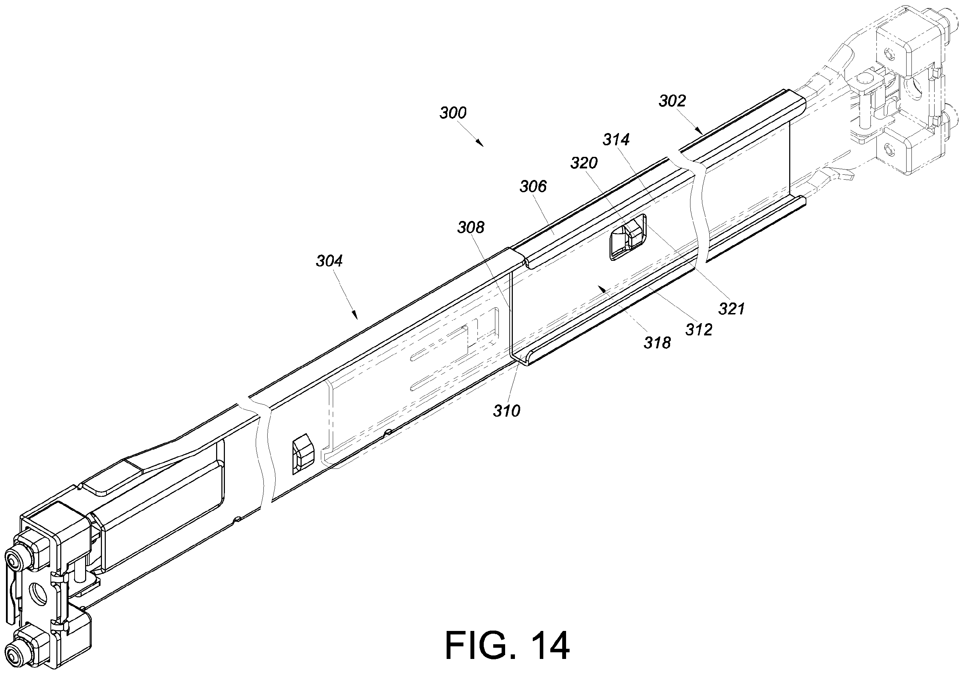

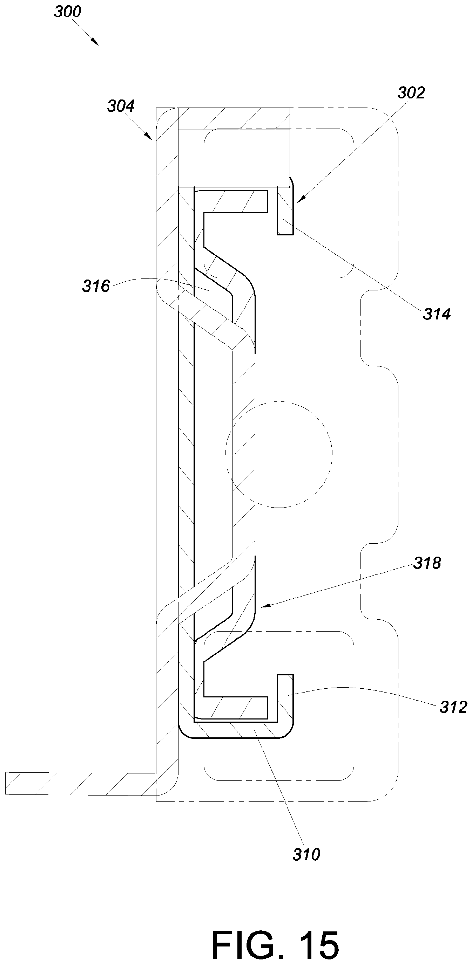

FIG. 13 to FIG. 15 show a supporting assembly 300 according to the second embodiment of the present invention. The supporting assembly 300 is different from the supporting assembly 22 of the first design substantially in that the supporting frame 302 is a separate component connected to the first bracket 304. For example, the supporting frame 302 may be fixedly connected to the first bracket 304 by riveting or soldering, or the supporting frame 302 may be detachably connected to the first bracket 304 through mechanical engagement or by a threaded means.

The supporting frame 302 has a second supporting section 306 as well as a first supporting section 310. The supporting frame 302 further has an intermediate wall 308 connected between the first supporting section 310 and the second supporting section 306. The first supporting section 310 is connected with a first bent section 312, and the second supporting section 306 is connected with a second bent section 314.

The first supporting section 310, the second supporting section 306, and the intermediate wall 308 define a supporting channel 316 for supporting the second bracket 318.

The intermediate wall 308 of the supporting frame 302 is formed with a hole 321 in order not to interfere with the first feature 320 of the first bracket 304. The first feature 320 of the first bracket 304 extends through the hole 321 in the intermediate wall 308 of the supporting frame 302 to work with the second feature 322 of the second bracket 318. The structural configurations and functions of the first feature 320 and of the second feature 322 are the same as those of their counterparts in the first design and therefore will not be repeated.

According to the above, the supporting assemblies disclosed herein preferably have the following features:
1. The supporting frame and the first bracket of each supporting assembly is such that the supporting frame is a separate component connected to the first bracket (according to the first and the second embodiment); the supporting frame serves to increase the structural strength of the supporting assembly. Moreover, the supporting frame of the second as well as the first embodiment may be detachably connected to the first bracket to facilitate assembly.
2. The supporting assemblies can be adjusted in length to adapt to racks of different depths.
3. The supporting assemblies are configured to be mounted on a rack to directly support the object they carry.

The scope of patent protection sought by the applicant is defined by the appended claims.

## Claims

1. A supporting assembly (200, 300), comprising:
a first bracket (204, 304) including a first end portion (34) and a second end portion (36);
a supporting frame (202, 302) connected to the first bracket (204, 304) at a position adjacent to the second end portion (36) of the first bracket (204, 304),
wherein the supporting frame (202, 302) has a first supporting section (214, 310); and
a second bracket (220, 318);
one of the first bracket (204, 304) and the supporting frame (202, 302) is provided with a second supporting section (206, 306), and the first supporting section (214, 310) and the second supporting section (206, 306) jointly constitute a supporting channel (207, 316) for supporting the second bracket (220, 318),
wherein the supporting frame (202, 302) is a separate component connected to the first bracket (204, 304),
wherein the first bracket (204, 304) has a first lateral side (L1) and a second lateral side (L2), and
the first lateral side (L1) is provided with a carrying portion (62, 216) for carrying an external object (20), the first supporting section (214, 310) is located on the second lateral side (L2), and the second supporting section (206, 306) is located on the second lateral side (L2),
the carrying portion (62) is arranged on the first lateral side (L1) of a sidewall (38) of the first bracket (28), is substantially adjacent to the a lower portion (58) of the side wall, and extends in a first direction (Dl),
the carrying portion (62) is configured to carry a bottom portion of the external object (20) in such a way that a lateral side of the external object (20) is configured to be pressed against and thereby supported by the first lateral side (L1) of a sidewall (38) of the first bracket (28), the first supporting section and the second supporting section extend in a second direction (D2) that is different from the first direction (D1), and
wherein the sidewall (38, 208) of the first bracket (204, 304) has a first feature (54, 320), the sidewall (48, 226) of the second bracket (220, 318) has a second feature (56, 322), the first feature (54, 320) and the second feature (56, 322) do not contact each other when the first bracket (204, 304) and the second bracket (220, 318) are extended to a first length (X1), and the first feature (54, 320) and the second feature (56, 322) contact each other -thereby setting a limit to the adjustment of the first bracket (204, 304) and the second bracket (220, 318) - when the first bracket (204, 304) and the second bracket (220, 318) are extended to a second length (X2),

2. The supporting assembly (200, 300) as claimed in claim 1, wherein the second bracket (220, 318) is mounted to the first bracket (204, 304) through the supporting channel (207, 316), the first bracket (204, 304) and the second bracket (220, 318) includes a first mounting member (40) and a second mounting member (50) respectively, and the second mounting member (50) is away from the first mounting member (40).

3. The supporting assembly (200, 300) as claimed in any of claims 1-2, wherein the first feature (54, 320) is one of a protruding portion and an elastic arm, and the second feature (56, 322) is the other of the protruding portion and the elastic arm.

4. The supporting assembly (200) as claimed in claim 1, wherein the first supporting section (214) is connected with a first bent section (218).

5. The supporting assembly (200) as claimed in any of claims 1-4, wherein the first bracket (204) has the second supporting section (206).

6. The supporting assembly (200) as claimed in any of claims 1-5, wherein the sidewall (208) has the first lateral side (L1) and the second lateral side (L2), the sidewall (208) further has an upper portion (210) and a lower portion (212), the first supporting section (214) is adjacent to the lower portion (212), and the second supporting section (206) is adjacent to the upper portion (60).

7. The supporting assembly (200) as claimed in any of claims 1-6, wherein the second bracket (220) includes an upper wall (222), a lower wall (224), and a sidewall (226) connected between the upper wall (222) and the lower wall (224); the lower wall (224) corresponds in position to the first supporting section (214); and the upper wall (222) corresponds in position to the second supporting section (206).

8. The supporting assembly (300) as claimed in claim 1, wherein the supporting frame (302) has the second supporting section (306) and an intermediate wall (308) connected between the first supporting section (310) and the second supporting section (306), the first supporting section (310) is connected with a first bent section (312), and the second supporting section (306) is connected with a second bent section (314).

9. The supporting assembly (200, 300) as claimed in claim 2 or as claimed in any of claims 3-8 when dependent on claim 2, wherein the supporting assembly (200, 300) is adapted to be mounted on a rack (26), the first bracket (204, 304) is mountable at a first position (P1) on a first side (S1) of the rack (26) through the first mounting member (40), and the second bracket (220, 318) is mountable at a second position (P2) on the first side (S1) of the rack (26) through the second mounting member (50).

10. The supporting assembly (300) as claimed in claim 8, wherein the intermediate wall (308) of the supporting frame (302) is formed with a hole (321) in order not to interfere with the first feature (320) of the first bracket (304), the first feature (320) of the first bracket (304) extends through the hole (321) in the intermediate wall (308) of the supporting frame (302) to work with the second feature (322) of the second bracket (318).

## Patentansprüche

1. Eine tragende Baugruppe (200, 300), umfassend:
eine erste Halterung (204, 304) mit einem ersten Endstück (34) und einem zweiten Endstück (36);
einen Tragrahmen (202, 302), der an der ersten Halterung (204, 304) an einer Position neben dem zweiten Endstück (36) der ersten Halterung (204, 304) befestigt ist, wobei der Tragrahmen (202, 302) ein erstes tragendes Element (214, 310) aufweist; und
eine zweite Halterung (220, 318);
eine der ersten Halterungen (204, 304) und des Tragrahmens (202, 302) ein zweites tragendes Element (206, 306) aufweist, während das erste tragende Element (214, 310) und das zweite tragende Element (206, 306) gemeinsam einen Trägerkanal (207, 316) zum Tragen der zweiten Halterung (220, 318) bilden,
wobei der Tragrahmen (202, 302) eine separate Komponente ist, die an der ersten Halterung (204, 304) befestigt ist,
wobei die erste Halterung (204, 304) eine erste laterale Seite (L1) und eine zweite laterale Seite (L2) aufweist, und
die erste laterale Seite (L1) mit einem tragenden Teil (62, 216) zum Tragen eines externen Objekts (20) versehen ist, das erste tragende Element (214, 310) auf der zweiten lateralen Seite (L2) angeordnet ist, und das zweite tragende Element (206, 306) auf der zweiten lateralen Seite (L2) angeordnet ist,
der tragende Teil (62) an der ersten lateralen Seite (L1) einer Seitenwand (38) des ersten Trägers (28) angeordnet ist, im Wesentlichen an einen unteren Teil (58) der Seitenwand angrenzt und sich in eine erste Richtung (D1) erstreckt,
der tragende Teil (62) so ausgelegt ist, dass er einen unteren Teil des externen Objekts (20) trägt
und zwar so, dass eine laterale Seite des externen Objekts (20) so ausgelegt ist, dass sie gegen die erste laterale Seite (L1) einer Seitenwand (38) der ersten Halterung (28) gedrückt und dadurch gestützt wird, wobei sich das erste tragende Element und das zweite tragende Element in einer zweiten Richtung (D2) erstrecken, die sich von der ersten Richtung (D1) unterscheidet, und
wobei die Seitenwand (38, 208) der ersten Halterung (204, 304) ein erstes Merkmal (54, 320) aufweist, die Seitenwand (48, 226) der zweiten Halterung (220, 318) ein zweites Merkmal (56, 322) aufweist, das erste Merkmal (54, 320) und das zweite Merkmal (56, 322) einander nicht berühren, wenn die erste Halterung (204, 304) und die zweite Halterung (220, 318) auf eine erste Länge (X1) ausgefahren sind, wobei das erste Merkmal (54, 320) und das zweite Merkmal (56, 322) einander berühren, wodurch eine Grenze für die Einstellung der ersten Halterung (204, 304) und der zweiten Halterung (220, 318) festgelegt wird - wenn die erste Halterung (204, 304) und die zweite Halterung (220, 318) auf eine zweite Länge (X2) ausgefahren sind.

2. Die tragende Baugruppe (200, 300) nach Anspruch 1, wobei die zweite Halterung (220, 318) an der ersten Halterung (204, 304) durch den Trägerkanal (207, 316) befestigt ist, die erste Halterung (204, 304) und die zweite Halterung (220, 318) aus einem ersten Befestigungselement (40) bzw. einem zweiten Befestigungselement (50) besteht, wobei sich das zweite Befestigungselement (50) in einem Abstand zum ersten Befestigungselement (40) befindet.

3. Die tragende Baugruppe (200, 300) nach einem der Ansprüche 1-2, wobei das erste Merkmal (54, 320) entweder ein vorstehender Teil und ein elastischer Arm ist, während das zweite Merkmal (56, 322) das andere des vorstehenden Teils und des elastischen Arms ist.

4. Die tragende Baugruppe (200, 300) nach Anspruch 1, wobei das erste tragende Element (214) an einem ersten gebogenen Teilstück (218) befestigt ist.

5. Die tragende Baugruppe (200, 300) nach einem der Ansprüche 1-4, wobei die erste Halterung (204) das zweite tragende Element (206) aufweist.

6. Die tragende Baugruppe (200, 300) nach einem der Ansprüche 1-5, wobei die Seitenwand (208) die erste laterale Seite (L1) und die zweite laterale Seite (L2) aufweist, die Seitenwand (208) weist ferner einen oberen Teil (210) und einen unteren Teil (212) auf, das erste tragende Element (214) dem unteren Teil (212) benachbart und das zweite tragende Element (206) dem oberen Teil (60) benachbart ist.

7. Die tragende Baugruppe (200) nach einem der Ansprüche 1-6, wobei die zweite Halterung (220) eine obere Wand (222), eine untere Wand (224) und eine zwischen der oberen Wand (222) und der unteren Wand (224) befestigte Seitenwand (226) aufweist; die untere Wand (224) entspricht in ihrer Position dem ersten tragenden Element (214), während die obere Wand (222) in ihrer Position dem zweiten tragenden Element (206) entspricht.

8. Die tragende Baugruppe (300) nach Anspruch 1, wobei der Tragrahmen (302) das zweite tragende Element (306) und eine Zwischenwand (308) aufweist, die zwischen dem ersten tragenden Element (310) und dem zweiten tragenden Element (306) befestigt ist, das erste tragende Element (310) an einem ersten gebogenen Teilstück (312) befestigt ist, während das zweite tragende Element (306) an einem zweiten gebogenen Teilstück (314) befestigt ist.

9. Die tragende Baugruppe (200, 300) nach Anspruch 2 oder nach einem der Ansprüche 3-8 in Abhängigkeit von Anspruch 2, wobei die tragende Baugruppe (200, 300) zur Montage an einem Gestell (26) montiert ist, die erste Halterung (204, 304) an einer ersten Position (P1) auf einer ersten Seite (S1) des Gestells (26) durch das erste Befestigungselement (40) montierbar ist, und die zweite Halterung (220, 318) an einer zweiten Position (P2) auf der ersten Seite (S1) des Gestells (26) durch das zweite Befestigungselement (50) montierbar ist.

10. Die tragende Baugruppe (300) nach Anspruch 8, wobei die Zwischenwand (308) des Tragrahmens (302) mit einem Loch (321) gebildet ist, um nicht mit dem ersten Merkmal (320) der ersten Halterung (304) zu kollidieren, wobei das erste Merkmal (320) der ersten Halterung (304) durch das Loch (321) in der Zwischenwand (308) des Tragrahmens (302) ragt, um mit dem zweiten Merkmal (322) der zweiten Halterung (318) zusammenzuwirken.

## Revendications

1. Ensemble de support (200, 300), **caractérisé par le fait qu'**il comprend :
un premier support (204, 304) comprenant une première partie d'extrémité (34) et une seconde partie d'extrémité (36) ;
un cadre de support (202, 302) relié au premier support (204, 304) à une position adjacente à la seconde partie d'extrémité (36) du premier support (204, 304), le cadre de support (202, 302) comporte une première section de support (214, 310) ; et
un second support (220, 318) ;
l'un des premier support (204, 304) et cadre de support (202, 302) est équipé d'une seconde section de support (206, 306), et la première section de support (214, 310) et la seconde section de support (206, 306) constituent conjointement
un canal de support (207, 316) pour supporter le second support (220, 318), le cadre de support (202, 302) est un composant séparé relié au premier support (204, 304),
le premier support (204, 304) comporte un premier côté latéral (L1) et un second côté latéral (L2), et
le premier côté latéral (L1) est équipé d'une partie porteuse (62, 216) pour porter un objet externe (20), la première section de support (214, 310) est située sur le second côté latéral (L2), et la seconde section de support (206, 306) est située sur le second côté latéral (L2),
la partie porteuse (62) est placée sur le premier côté latéral (L1) d'une paroi (38) du premier support (28), est sensiblement adjacente à une partie inférieure (58) de la paroi, et s'étend dans une première direction (D1),
la partie porteuse (62) est configurée pour porter une partie inférieure de l'objet externe (20) de manière à ce qu'un côté latéral de l'objet externe (20) est configuré pour être appuyé contre et ainsi soutenu par le premier côté latéral (L1) d'une paroi (38) du premier support (28), la première section de support et la seconde section de support s'étendent dans une seconde direction (D2) qui est différente de la première direction (D1), et
la paroi (38, 208) du premier support (204, 304) comporte une première fonctionnalité (54, 320), la paroi (48, 226) du second support (220, 318) comporte une seconde fonctionnalité (56, 322), la première fonctionnalité (54, 320) et la seconde fonctionnalité (56, 322) ne sont pas en contact lorsque le premier support (204, 304) et le second support (220, 318) sont étendus sur une première longueur (X1), et la première fonctionnalité (54, 320) et la seconde fonctionnalité (56, 322) sont en contact - fixant ainsi une limite à l'ajustement du premier support (204, 304) et du second support (220, 318) - lorsque le premier support (204, 304) et le second support (220, 318) sont étendus sur une second longueur (X2),

2. Ensemble de support (200, 300) selon la revendication 1, **caractérisé par le fait que** le second support (220, 318) est monté sur le premier support (204, 304) à travers le canal de support (207, 316), le premier support (204, 304) et le second support (220, 318) comprennent respectivement un premier élément de montage (40) et un second élément de montage (50), et le second élément de montage (50) est à l'écart du premier élément de montage (40).

3. Ensemble de support (200, 300) selon l'une quelconque des revendications 1-2, **caractérisé par le fait que** la première fonctionnalité (54, 320) est l'une d'une partie saillante et d'un bras élastique, et la seconde fonctionnalité (56, 322) est l'autre d'une partie saillante et d'un bras élastique.

4. Ensemble de support (200) selon la revendication 1, **caractérisé par le fait que** la première section de support (214) est reliée à une première section courbée (218).

5. Ensemble de support (200) selon l'une quelconque des revendications 1-4, **caractérisé par le fait que** le premier support (204) comporte la seconde section de support (206).

6. Ensemble de support (200) selon l'une quelconque des revendications 1-5, **caractérisé par le fait que** la paroi (208) comporte le premier côté latéral (L1) et le second côté latéral (L2), la paroi (208) comporte en outre une partie supérieure (210) et une partie inférieure (212), la première section de support (214) est adjacente à la partie inférieure (212), et la seconde section de support (206) est adjacente à la partie supérieure (60).

7. Ensemble de support (200) selon l'une quelconque des revendications 1-6, **caractérisé par le fait que** le second support (220) comprend une paroi supérieure (222), une paroi inférieure (224), et une paroi (226) reliée entre la paroi supérieure (222) et la paroi inférieure (224) ; la paroi inférieure (224) correspond en position à la première section de support (214) ; et la paroi supérieure (222) correspond en position à la seconde section de support (206).

8. Ensemble de support (300) selon la revendication 1, **caractérisé par le fait que** le cadre de support (302) comporte la seconde section de support (306) et une paroi intermédiaire (308) reliée entre la première section de support (310) et la seconde section de support (306), la première section de support (310) est reliée à une première section courbée (312), et la seconde section de support (306) est reliée à une seconde section courbée (314).

9. Ensemble de support (200, 300) selon la revendication 2 ou selon l'une quelconque des revendications 3-8 lorsque dépendante de la revendication 2, **caractérisé par le fait que** l'ensemble de support (200, 300) est adapté pour être monté sur un rack (26), le premier support (204, 304) est montable sur une première position (P1) sur un premier côté (S 1) du rack (26) à travers le premier élément de montage (40), et le second support (220, 318) est montable sur une seconde position (P2) sur le premier côté (S1) du rack (26) à travers le second élément de montage (50).

10. Ensemble de support (300) selon la revendication 8, **caractérisé par le fait que** la paroi intermédiaire (308) du cadre de support (302) est formé avec un trou (321) afin de ne pas interférer avec la première fonctionnalité (320) du premier support (304), la première fonctionnalité (320) du premier support (304) s'étend à travers le trou (321) dans la paroi intermédiaire (308) du cadre de support (302) pour travailler avec la seconde fonctionnalité (322) du second support (318).
